# EUROPEAN PATENT APPLICATION

(11) **EP 2 720 237 A1**
(43) Date of publication of application: **16.04.2014**
(21) Application number: 12188024.9
(22) Date of filing: 10.10.2012
(51) Int. Cl.: H01G 9/20

(54) **Electrochemical and optoelectronic devices and dye-sensitizers comprised therein**

(71) Applicant: Solvay SA, 1120 Bruxelles (BE)
(72) Inventor: The designation of the inventor has not yet been filed
(74) Representative: Mross, Stefan P.M.

(57) **Abstract**

The present invention relates to electrochemical and optoelectronic devices comprising a cobalt complex operatively connected to a dye-sensitizer comprising at least one thiophene moiety. Also, novel dye-sensitizers, methods of making the same and their use in electrochemical and optoelectronic devices are disclosed.

## Description

The present invention relates to electrochemical and optoelectronic devices comprising cobalt complexes operatively connected to a dye-sensitizer as well as to compounds useful as dye-sensitizers, methods of making the same and their use in electrochemical and optoelectronic devices.

Conventional solar cells convert light into electricity by exploiting the photovoltaic effect that exists at semiconductor junctions. In other words, the commercial solar cells absorb energy from visible light and converts excited charge carriers thereof to electric energy. At present, the main commercial solar cells are silicon-based solar cells. For a silicon-based solar cell, there are shortcomings in that high energy costs for material processing is required and many problems are to be addressed such as environmental burdens and material supply limitations.

Recently, attempts have been undertaken to develop novel low-cost organic solar cells. Examples are the small-molecule solar cell and the polymer solar cell.

Another example is the dye-sensitized solar cell (DSSC), which is a class of photovoltaic cells based on a photoanode comprising a semiconductor and a dye-sensitizer, an electrolyte comprising an electron-transfer mediator, and a counter electrode. The dye-sensitizers are molecules sensible to the visible light and are anchored to the semiconductor. The light creates and excites a highly energetic electron in the dye-sensitizer. The electron is rapidly injected into the semiconductor. The oxidized dye-sensitizer formed after the injection of the electron is regenerated by the electron-transfer mediator, which is contained in the electrolyte. The electrolyte is in contact with the semiconductor/dye-sensitizer arrangement.

The DSSC offers the prospect of a cheap and versatile technology for large scale production of solar cells as it has advantages over silicon-based solar cells in terms of simplified processing steps and low fabrication cost.

The dye-sensitized solar cells generally have lower photoelectric conversion efficiency (PCE) over that of the silicon-based solar cells. Additionally, problems with stability of the dye-sensitizer and other components have been described. In an attempt to address these problems, DSSCs have been reported containing a dye-sensitizer and a cobalt complex (Journal of the American Chemical Society 2010, 132, 16714-724).

However, there is still a need for new electrochemical and optoelectronic devices, new combinations of dye-sensitizers with redox couples as well as new dye-sensitizers that could lead to an improvement in the photoelectric conversion efficiency as well as in the stability of the devices. For example, there is still a need for dye-sensitizers exhibiting a broad spectrum of adsorbed light (i.e. absorbing as much of the solar spectrum as possible), a high molar extinction coefficient, contributing to the long-term stability of the device and/or allowing an improved photoelectric conversion efficiency.

Accordingly, it is an object of the present invention, amongst other objects to provide new electrochemical and/or optoelectronic devices showing particularly advantageous properties like for example an improved photoelectric conversion efficiency and/or an improved short-circuit current density (J_{sc}).

Additionally, it is an object of the invention to provide new electrochemical and/or optoelectronic devices showing an improved electron transport to the dye-sensitizer and/or an improved mass transport in the semiconductor.

Furthermore, it is an object of the invention to provide new electrochemical and/or optoelectronic devices showing an improved stability.

It is another object of the invention to provide new dye-sensitizers having a broad absorption spectrum, particularly in the visible and near-IR regions, i.e. absorbing as much of the solar spectrum as possible. The new dye-sensitizers of the present invention also advantageously exhibit a high molar extinction coefficient. Furthermore, the dye-sensitizer could also advantageously have an improved communication and directionality of the electrons when being transferred from the sensitizer to the semiconductor electrode. Such dye-sensitizers could also advantageously contribute to the long-term stability of the devices containing them, for example, by an improved resistance to compounds contained in trace amounts in the devices such as for example water.

Consequently, a first aspect of the present invention relates to an electrochemical and/or optoelectronic device comprising a cobalt complex operatively connected to a dye-sensitizer of formula

D-π¹-B-π²-A wherein D is a π-electron donor group, A is a π-electron acceptor group, π¹ and π² are optional bridge groups, and B is a π-electron bridge group of the formula

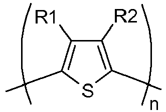

wherein n is 1, 2, 3, 4, or 5; R1 and R2 independently
are -(O)ₘ-alkyl, -(O)ₘ-cycloalkyl, -(O)ₘ₋alkenyl, -(O)ₘ-alkynyl, -(O)ₘ-aryl, or -(O)ₘ-heteroaryl and m is 0 or 1; or R1 and R2 together form an optionally substituted alkylene, an optionally substituted -O-alkylene-O- or an optionally substituted annulated aryl or an optionally substituted annulated heteroaryl.

The term "alkyl" is intended to denote in particular a linear or branched alkyl group comprising from 1 to 20 carbon atoms, preferably 1, 2, 3, 4, 5, 6, 7, 8, 9 or 10 carbon atoms. Specific examples of such substituents are methyl, ethyl, n-propyl, isopropyl, n-butyl, isobutyl, tert-butyl, n-pentyl, isopentyl, n-hexyl, 2-hexyl, n-heptyl, n-octyl and benzyl. The alkyl group can optionally be substituted, e.g. by halogen.

The term "alkenyl" is intended to denote a linear or branched alkenyl group or a cycloalkenyl group comprising 2 to 20 carbon atoms and at least one C=C double bond. The stereochemistry at the double bond(s) may be (E) or (Z). Specific examples of such groups are vinyl, 1-allyl, 2-allyl, n-but-2-enyl, isobutenyl, 1,3-butadienyl, cyclopentenyl, cyclohexenyl and styryl. The akenyl group can optionally be substituted, e.g. by halogen.

The term "alkynyl" is intended to denote a linear or branched alkynyl group comprising 2 to 20 carbon atoms and at least one C≡C triple bond. Specific examples of such groups are ethinyl, 1-propinyl, 2-propinyl, n-but-2-inyl and 2-phenylethinyl. The akynyl group can optionally be substituted, e.g. by halogen.

The term "cycloalkyl" is intended to denote in particular a group comprising at least one saturated carbocycle containing 3 to 10 carbon atoms, preferably 5, 6 or 7 carbon atoms. Specific examples of such substituents are cyclopropyl, cyclobutyl, cyclopentyl, cyclohexyl and cycloheptyl. The cycloalkyl group can optionally be substituted, e.g. by halogen.

The term "aryl" is intended to denote a group which derives from an aromatic nucleus such as, in particular, a C6-C10 aromatic nucleus. Specific examples of such groups are phenyl, 1-tolyl, 2-tolyl, 3-tolyl, xylyl, 1-naphthyl and 2-naphthyl, in particular phenyl or naphthyl. The aryl group can optionally be substituted, e.g. by halogen, alkyl, or cycloalkyl.

The term "heterocycle" is intended to denote in particular a cyclic group comprising at least one saturated or unsaturated ring made up of 3, 4, 5, 6, 7 or 8 atoms, at least one of which is a hetero atom. The hetero atom is often chosen from B, N, O, Si, P and S. It is more often chosen from N, O and S. Specific examples of such heterocycles are aziridine, azetidine, pyrrolidine, piperidine, morpholine, 1,2,3,4-tetrahydroquinoline, 1,2,3,4-tetrahydroisoquinoline, perhydroquino line, perhydroisoquino line, isoxazolidine, pyrazoline, imidazoline, pyrazole, imidazole, thiazoline, tetrahydrofuran, furan, tetrahydrothiophene, thiophene, pyran, tetrahydropyran and dioxane.

The term "alkylene" is intended to denote in particular a C2 to C7 alkylene group, including a vinylidene group, wherein the alkylene group preferably comprises a bridge of 2, 3, 4, 5, or 6 carbon atoms, more preferably 2 carbon atoms. The alkylene group can optionally be substituted, e.g. by halogen, alkyl, or cycloalkyl.

The term "annulated" is intended to denote two cyclic groups in a molecule that are condensed side-on and that share at least one bond.

In a preferred embodiment, R1 and R2 together form an optionally substituted -O-alkylene-O-. In a more preferred embodiment R1 and R2 together form -O-ethylene-O-.

In another preferred embodiment of this aspect of the invention A is X, -(CH=)ₚCHXY, -(CH=)ₚCX₂Y, -(CX=)CHXY, or rhodanine-3-CH₂-X, wherein X and Y are suitably chosen to allow the formation of a coordination complex of acceptor group A with a metal ion; more preferably X is -COOH, -PO₃H₂, -PO₄H₂, -SO₃H, -CONHOH, -NO₂, -CN, -NHOH or -(CF₂)ᵣCF₃, and Y is -COOH, -PO₃H₂, -PO₄H₂, -SO₃H, -CONHOH, -NO₂, -CN, -NHOH, -(CF₂)ᵣCF₃ or H; and p and r are independently 0, 1, 2, 3, 4, or 5. In an even more preferred embodiment A is -CH=CH(CN)COOH or rhodanine-3-acetic acid. The term "rhodanine" is intended to denote 2-sulfanylidene-1,3-thiazolidin-4-one.

In another preferred embodiment the π-electron donor group D is selected from: 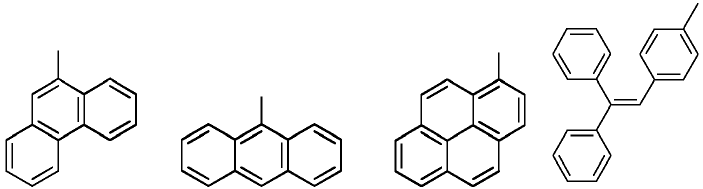 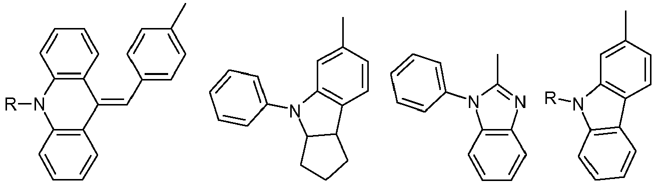 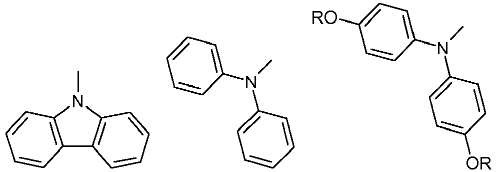 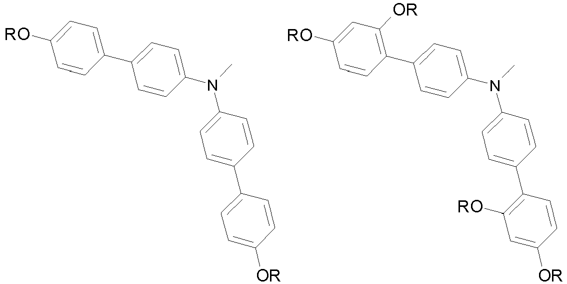 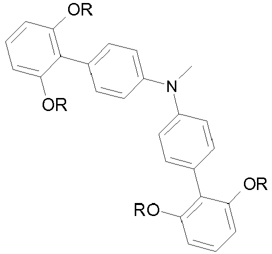 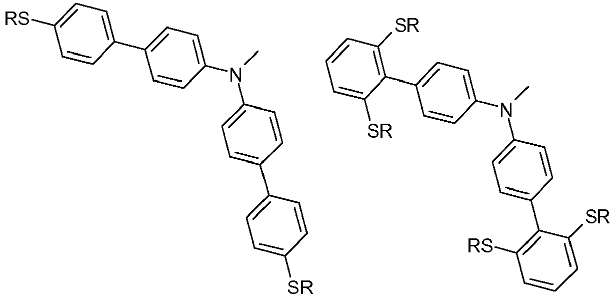 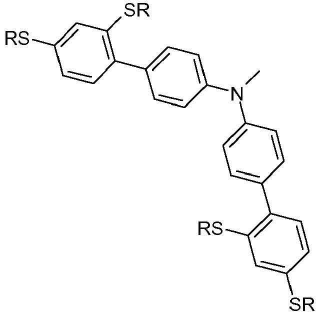 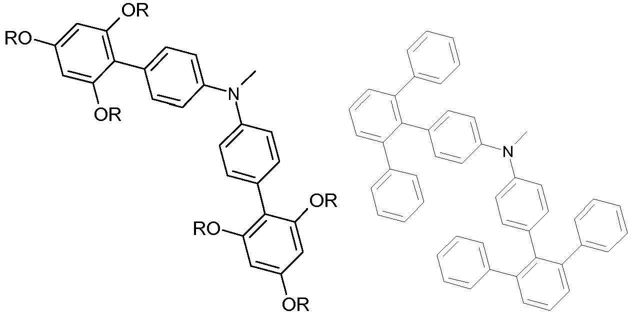 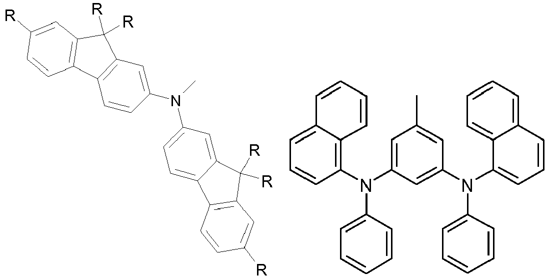 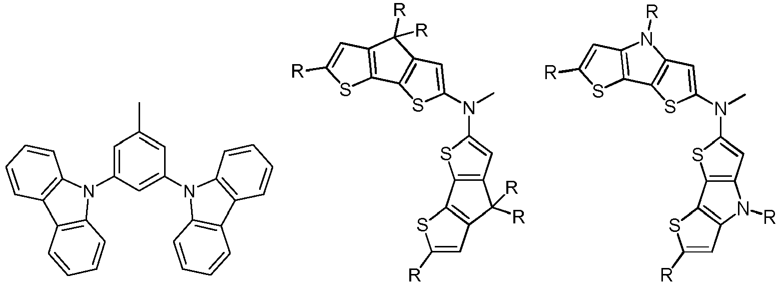 wherein R is independently selected from hydrogen, -CN, optionally branched C1-C18 alkyl and optionally substituted C6-C12 aryl. In a more preferred embodiment R is independently selected from optionally branched C6-C12 alkyl and optionally substituted C6 aryl. In the most preferred embodiment R is selected from linear C6-C12 alkyl.

The present invention also relates to electrochemical and optoelectronic devices comprising a semiconductor material. Preferably, the semiconductor material is selected from the group of titanium salts and tin salts, more preferably the semiconductor material is selected from the group of Ti02, Sn02 and TiOF2, most preferably the dye-sensitizer is anchored to TiOF2, for example in form of nanoparticles well connected to their neighbors.

The TiOF₂ is preferably used in the form of TiOF₂ nanoparticles, in particular TiOF₂ particles having a mean primary particle size from 15 to 50 nm. The layer thickness is typically from 500 nm to 20 µm. The TiOF₂ may be used as the sole semiconductor or may be combined with any other suitable semiconductor compound, for instance TiO₂. Another possibility is to have at first a dense TiO₂ layer on the conducting glass followed by a nanoporous TiOF₂ layer.

The term "anchored to" is intended to denote a chemical or physicochemical interaction between the dye-sensitizer and the semiconductor material, e.g. by means of a covalent bond, an ionic bond or a hydrogen bond.

The structure of the dye-sensitizer may optionally contain an additional bridge group π¹ between the donor group D and the bridge group B and/or an additional bridge group π² between the bridge group B and the acceptor group A. Both bridges π¹ and π² may be absent. "Absent" as used herein is intended to mean that π¹ and/or π² refer to a covalent bond. Thus, (D) is directly connected with (B) and (B) is directly connected with (A). Alternatively, bridge π¹ may be absent and bridge π² electronically conjugating (B) with (A) may be present.

Preferably, both bridges π¹ and π² are present.

Also preferably, bridge π¹ electronically conjugating (D) with (B) is present and bridge π² is absent.

Thus, in another preferred embodiment the dye-sensitizer refers to a formula wherein π¹ and π² are selected, independently of each other, from a covalent bond, an aromatic ring system, an alkene, an alkyne or a heteroatom-containing variant of such systems wherein one or more carbon atoms are replaced by a heteroatom. In a more preferred embodiment, π¹ and π² are selected from an alkene group and a phenyl moiety. Most preferably, π¹ and π² are independently selected from -(CH=CH)ₙ-, wherein n is 1, 2, 3, 4, 5, 6, 7, 8, 9, or 10, or a phenyl group. In a most preferred embodiment, π¹ is phenyl and π² is a covalent bond.

In another preferred embodiment the dye-sensitizer is selected from the group consisting of:

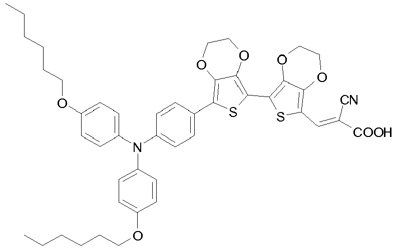

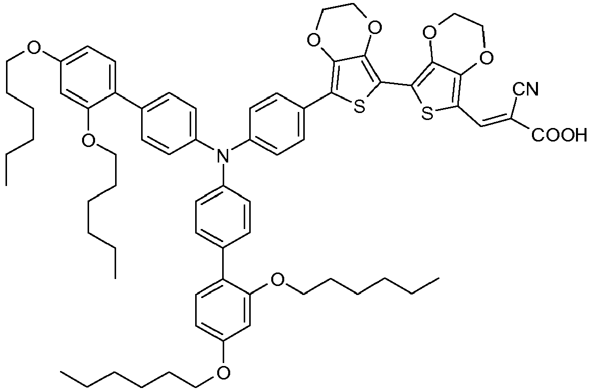

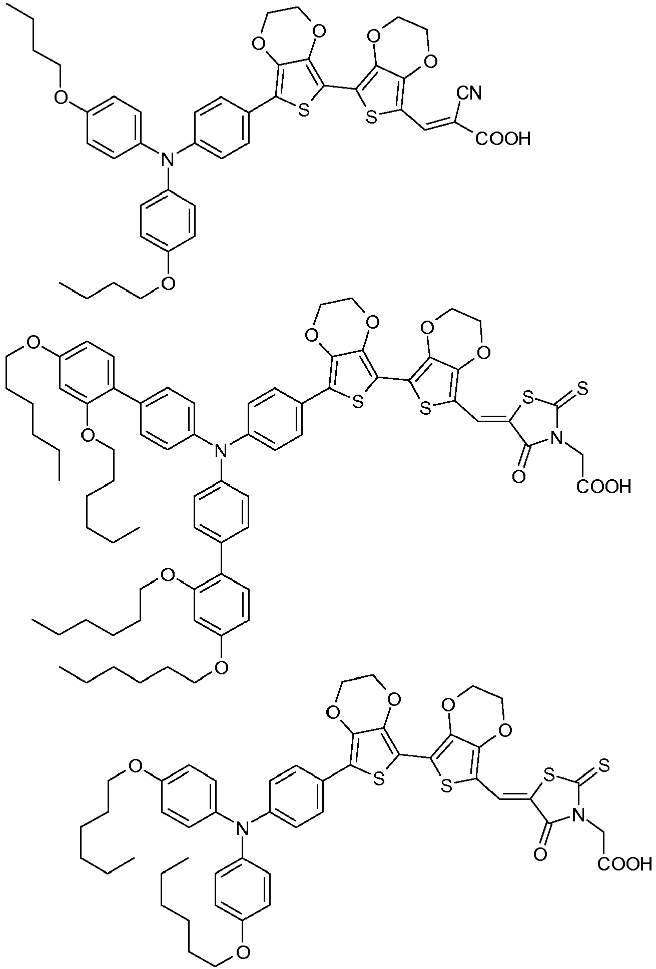

The cobalt complex comprised in the electrochemical and optoelectronic devices of the present invention comprises the ions Co²⁺ and Co³⁺. Without being bound to a theory it is believed that the cobalt complex can serve as a electron-transfer mediator and is present as a redox couple. The ligands in coordination with the cobalt ions in the cobalt complex may be monodentate, bidentate or tridentate or a mixture thereof. The number of ligands in coordination with the cobalt ion depends on the nature of the ligand. For example, the cobalt complex may comprise six monodentate ligands, or three bidentate ligands or two tridentate ligands. In case a bidentate or a tridentate ligand is present the ligand may comprise 1, 2, 3, 4, or 5 aromatic rings or heterocyclic rings or mixtures thereof which are linked together by means of a covalent bond, by a chain comprising 1, 2, 3, or 4 atoms selected from C, O, N or S, or the rings are annulated or a mixture thereof.

Thus, in another preferred embodiment the cobalt complex refers to formula Co^{2+/3+}-L_{q}, wherein q is 1, 2, 3, 4, 5, or 6, and refers to the appropriate number of ligands present on the cobalt, L is independently selected from fluoride, chloride, bromide, iodide, optionally substituted pyridine, optionally substituted pyrazole, optionally substituted pyrazine, optionally substituted triazole, optionally substituted pyridazine, and optionally substituted imidazole or L is independently selected from a bidentate or a tridentate ligand comprising 1, 2, 3, 4, or 5 linked aromatic rings or linked heterocyclic rings or mixtures thereof independently selected from optionally substituted phenyl, optionally substituted naphthyl, optionally substituted pyridine, optionally substituted pyrazole, optionally substituted pyrazine, optionally substituted triazole, optionally substituted pyridazine, and optionally substituted imidazole ; wherein the substituents are independently selected from hydrocarbons comprising 1 to 40 carbon atoms and 0 to 20 heteroatoms, halogen, (-F, -Cl, -Br, -I), -NO₂, -NH₂ and -OH. In a more preferred embodiment L is independently selected from:

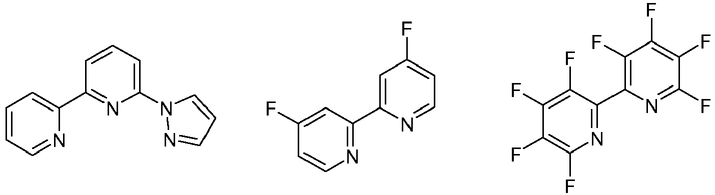

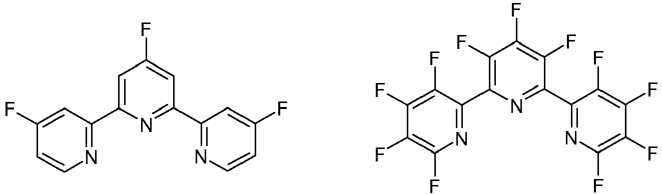

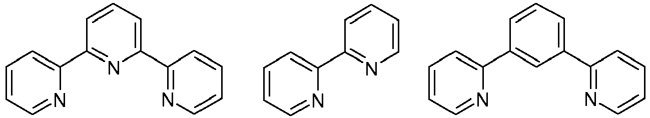

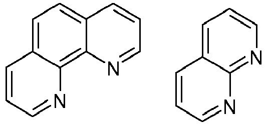

A second aspect of the invention relates to a compound of formula D-π¹-B-π²-A, wherein D is a π-electron donor group of the general formula 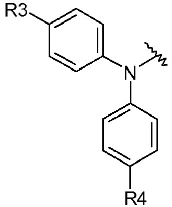 wherein R3 and R4 independently are selected from optionally branched -O-C6-C12-alkyl and optionally substituted C6 aryl, A is a π-electron acceptor group, π¹ and π² are optional bridge groups, and B is a π-electron bridge group of the formula 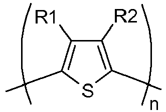 wherein n is 2, 3, 4, or 5; R1 and R2 independently
are -(O)ₘ-alkyl, -(O)ₘ-alkenyl, -(O)ₘ-alkynyl, -(O)ₘ-aryl or -(O)ₘ-heteroaryl, or R1 and R2 together form an optionally substituted -(O)ₘ-alkylene-(O)ₘ- or an optionally substituted annulated aryl or an optionally substituted annulated heteroaryl; wherein m is 0 or 1. In a preferred embodiment of this aspect of the invention n is 2.

In another preferred embodiment of this aspect R3 and R4 are independently selected from linear C6-C12 alkyl groups and substituted phenyl groups. In a more preferred embodiment R3 and R4 are independently selected from -O-n-hexyl or 2,4-di-(n-hexyloxy)phenyl.

In another preferred embodiment of this aspect R1 and R2 together form -O-ethylene-O-.

The compound may optionally contain an additional bridge group π¹ between the donor group D and the bridge group B and/or an additional bridge group π² between the bridge group B and the acceptor group A. Both bridges π¹ and π² may be absent. "Absent" as used herein is intended to mean that π¹ and/or π² refer to a covalent bond. Thus, (D) is directly connected with (B) and (B) is directly connected with (A). Alternatively, bridge π¹ may be absent and bridge π² electronically conjugating (B) with (A) may be present.

Preferably, both bridges π¹ and π² are present.

Also preferably, bridge π¹ electronically conjugating (D) with (B) is present and bridge π² is absent.

Thus, in another preferred embodiment π¹ and π² are selected, independently of each other, from an a covalent bond, an aromatic ring system, an alkene, an alkyne or a heteroatom-containing variant of such systems wherein one or more carbon atoms are replaced by a heteroatom. In a more preferred embodiment, π¹ and π² are selected from an alkene group and a phenyl moiety. Most preferably, π¹ and π² are independently selected from -(CH=CH)ₙ-, wherein n is 1, 2, 3, 4, 5, 6, 7, 8, 9, or 10, or a phenyl group. In a most preferred embodiment, π¹ is phenyl and π² is a covalent bond.

In yet another preferred embodiment of this aspect of the invention A is X, -(CH=)ₚCHXY, -(CH=)ₚCX₂Y, -(CX=)CHXY, or rhodanine-3-CH₂-X, wherein X and Y are suitably chosen to allow the formation of a coordination complex of acceptor group A with a metal ion; more preferably X is -COOH, -PO₃H₂, -PO₄H₂, -SO₃H, -CONHOH, -NO₂, -CN, -NHOH or -(CF₂)ᵣCF₃, and Y is -COOH, -PO₃H₂, -PO₄H₂, -SO₃H, -CONHOH, -NO₂, - CN, -NHOH, -(CF₂)ᵣCF₃ or H; and p and r are independently 0, 1, 2, 3, 4, or 5. In an even more preferred embodiment A is -CH=CH(CN)COOH or rhodanine-3-acetic acid. Specifically, A is -CH=CH(CN)COOH.

In a further preferred embodiment of this aspect of the invention the compound is selected from:

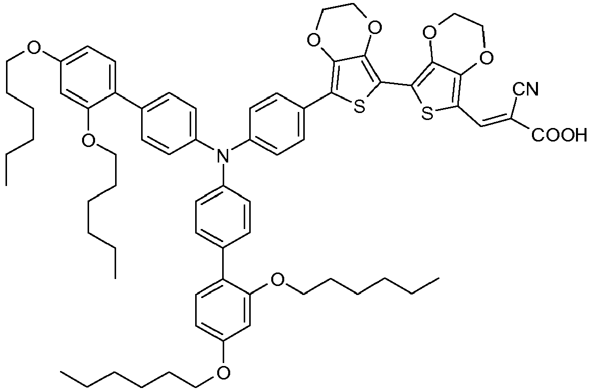

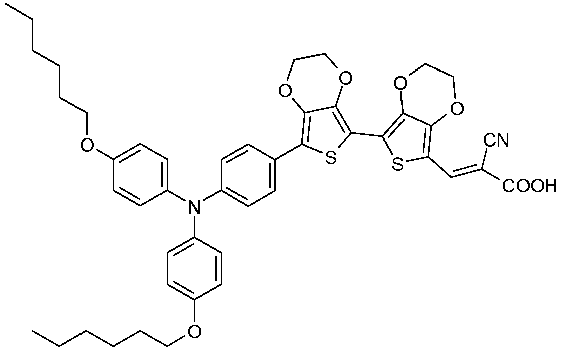

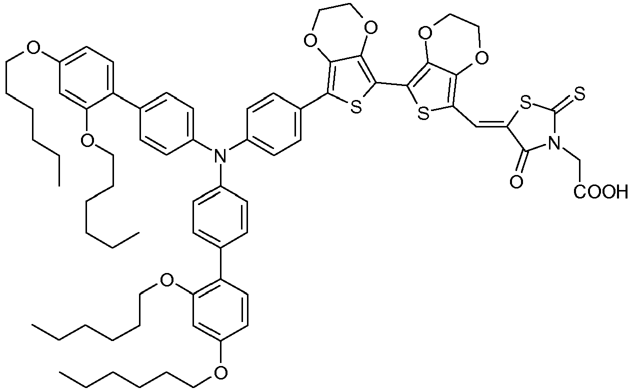

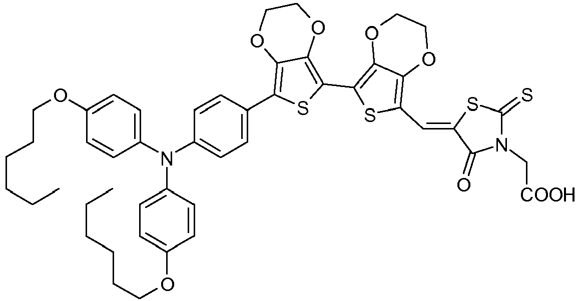

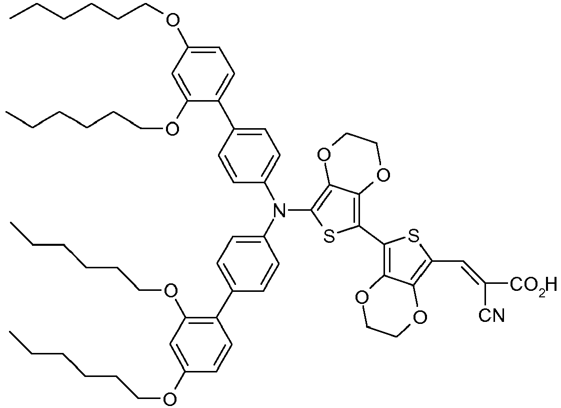

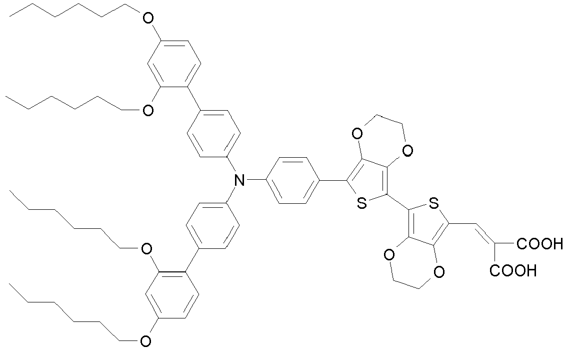

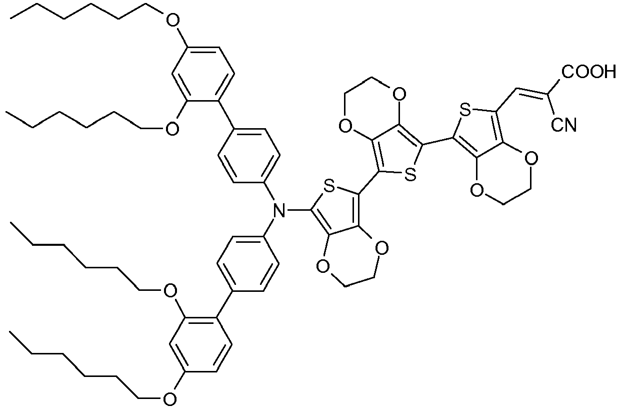

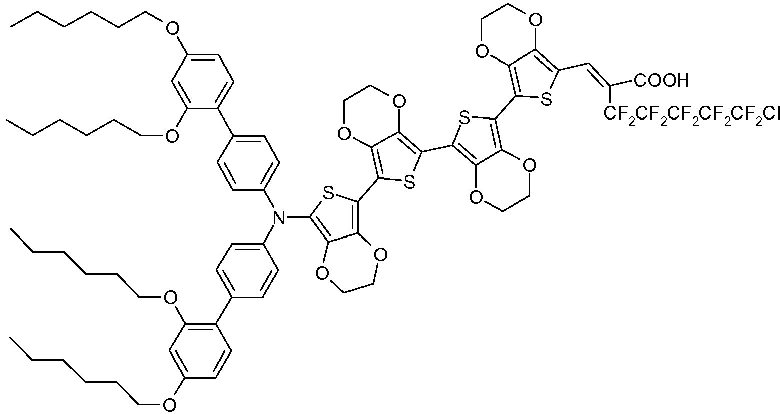

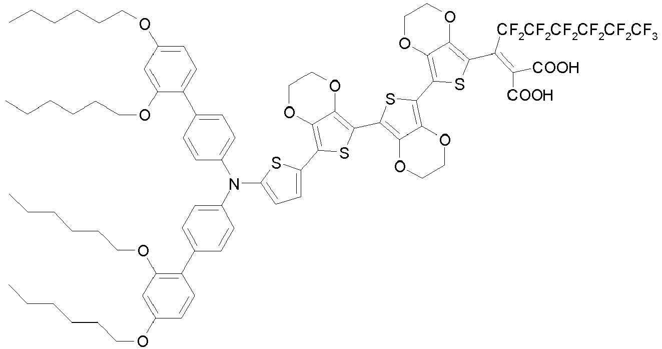

In a third aspect the present invention relates to an electrochemical and/or optoelectronic device, preferably a dye-sensitized solar cell, comprising any of the compounds of the invention as described above. The compound of the present invention is used as a dye-sensitizer in such device or cell.

The present invention further relates to a method for making the above-mentioned compounds of the invention, in particular by transition-metal catalyzed cross-coupling reaction, preferably by tin-mediated Stille coupling, a Vilsmeier-Haack reaction, and a Knoevenagel condensation reaction.

The compound of the present invention may be further isolated, for instance by column chromatography, preferably by high pressure liquid chromatography (HPLC).

While preferred embodiments of this invention have been shown and described, modifications thereof can be made by one skilled in the art without departing from the spirit or teaching of this invention. The embodiments described herein are exemplary only and are not limiting. Many variations and modifications of systems and methods are possible and are within the scope of the invention. Accordingly, the scope of protection is not limited to the embodiments described herein, but is only limited by the claims that follow, the scope of which shall include all equivalents of the subject matter of the claims.

### Examples

List of abbreviations:
RT - room temperature
Pd₂dba₃ - tris(dibenzylideneacetone)dipalladium(0)
X-Phos - 2-Dicyclohexylphosphino-2',4',6'-triisopropylbiphenyl
DCM - dichloromethane

### 2-(2,4-bis(hexyloxy)phenyl)-4,4,5,5-tetramethyl-1,3,2-dioxaborolane

In a 100 mL single-neck round-bottom flask, 8.56 grams of bishexyloxy-4-chloro-resorcinol (27.36 mmol), 10.42 grams of bis(pinacolato)diboron (41.03 mmol), and 8.06 grams potassium acetate (82.12 mmol) were dissolved in 60 mL of dioxane. This solution was degassed for 20 minutes with a stream of N₂, after which time 10 mg of Pd₂dba₃ and 20 mg of X-Phos were added simultaneously, in one batch. The reaction was then brought to 95 °C for 10 hours. The reaction was then cooled to RT, and plugged through a thin pad of MgSO₄ with DCM. The crude product was purified with gradient silica gel chromatography: 100% hexanes to 20:80 Hexane:DCM. 6.23 grams (70% yield) of a pure clear oil was obtained. ¹H NMR (400 MHz, Methylene Chloride-d2) δ 7.54 (d, *J* = 8.2 Hz, 1H), 6.46 (dd, *J* = 8.2, 2.2 Hz, 1H), 6.40 (d, *J* = 2.2 Hz, 1H), 3.96 (dt, *J* = 14.4, 6.4 Hz, 4H), 1.85 - 1.72 (m, 4H), 1.61 - 1.42 (m, 4H), 1.41 - 1.34 (m, 8H), 1.32 (s, 12H), 0.99 - 0.86 (m, 6H) ppm. ¹³C NMR (100 MHz, CD₂Cl₂) δ = 165.58, 163.11, 137.71, 129.65, 105.10, 99.20, 83.17, 82.81, 68.20, 67.88, 31.66, 31.58, 29.32, 29.20, 25.68, 25.67, 24.83, 24.64, 22.71, 22.60, 13.88, 13.80 ppm.

### N-(4-Bromophenyl)-4-iodo-N-(4-iodophenyl)benzenamine

A mixture of compound 4-bromo-*N*,*N*-diphenylaniline (3.2 g, 9.87 mmol), KI (2.23 g, 13.42 mmol), and KIO₃ (1.415 g, 6.6 mol) was stirred at 85 °C in 50 ml HOAc for 12 h. After cooling to RT, aq. NaHSO₃ (50 mL) was added and the reaction mixture was stirred for 20 min. The solution was extracted with CH₂Cl₂ (3 x 50 mL), and the organic layer was dried with MgSO₄. After removal of the solvent, the crude product was purified by recrystallization (CH₂Cl₂/MeOH) to afford the target product as a white solid (5.57g, 96 %). ¹H NMR (400 MHz, CDCl₃) δ 7.47 (m, 4 H), 7.28 (m, 2 H), 6.86 (m, 2 H), 6.74 (m, 4 H) ppm. ¹³C NMR (101 MHz, CDCl₃) δ 146.7, 145.9, 138.5, 132.6, 126.0, 116.3, 86.5 ppm.

### Hagfelt donor

2-(2,4-bis(hexyloxy)phenyl)-4,4,5,5-tetramethyl-1,3,2-dioxaborolane (1 g, 2.473 mmol), N-(4-Bromophenyl)-4-iodo-N-(4-iodophenyl)benzenamine (647 mg, 1.124 mmol) were dissolved in toluene (30 ml). A K₂CO₃ solution (2M) (2.764 g in 10 ml H₂O) was also added. The biphasic system was bubbled with N₂ for 20 min. Then Pd(PPh₃)₄ (40 mg) was added and the system was heated to 85 °C and kept at that temperature for 24 hours. Purification using hexane/DCM (3:1 v/v) as eluent yielded 818 mg, 83% as a light yellow oil. ¹H NMR (400 MHz, CD₂Cl₂) δ 7.50 (m, 4 H), 7.40 (m, 2 H), 7.28 (d, 2 H, *J*= 8.4 Hz), 7.16 (m, 4 H), 7.08 (m, 2 H), 4.01 (m, 8 H), 1.82 (m, 8 H), 1.44 (m, 28 H), 0.97 (m, 14 H) ppm. ¹³C NMR (101 MHz, CD₂Cl₂) δ 159.8, 157.0, 147.2, 145.5, 133.6, 132.0, 130.7, 130.3, 125.0, 123.8, 122.6, 114.3, 105.4, 100.2, 99.8, 68.0, 31.6, 29.2, 25.6, 22.7, 13.9.

### Tributyl(2,2',3,3'-tetrahydro-[5,5'-bithieno[3,4-b][1,4]dioxin]-7-yl)stannane

2,2',3,3'-tetrahydro-[5,5'-bithieno[3,4-b][1,4]dioxin (1.5 g, 5.3 mmol) was dissolved in dry THF (30 mL) under Ar. The solution was cooled to -60 °C using a liquid N₂/CHCl₃ bath. The hexane solution of n-BuLi (2.0 mL, 5.5 mmol) was added dropwise with a gas-tight syringe. The reaction mixture was stirred in the dark. The reaction temperature was gradually raised to -15 °C using an ice bath. After 1 h, the reaction mixture was cooled to -60 °C again using a liquid N₂/CHCl₃ bath. Tri-n-butyltin chloride (ClSn(n-Bu)₃, 1.4 mL, 5.2 mmol) was added dropwise to the reaction mixture. The reaction temperature was gradually raised to room temperature by removing the liquid N₂/CHCl₃ bath. After 1 h, CH₂Cl₂ (200 mL) was added to the reaction mixture and washed with 1 N NaHCO₃ (200 mL) aqueous solution. The organic layer was dried (MgSO₄), filtered, and evaporated. The residue was purified by preparative HPLC to give a dark green oil. Yield: 1.5 g (49%). 1H NMR (CDCl₃, 400 MHz): δ = 0.90 (t, J=7.3 Hz, 9H), 1.12 (t, J=7.8 Hz, 6H), 1.34 (m, 6H), 1.56 (m, 6H), 4.18 (m, 2H), 4.24 (m, 2H), 4.27 (m, 2H), 4.33 (m, 2H), 6.24 (s, 1H).

### N-(2',4'-bis(hexyloxy)-[1,1'-biphenyl]-4-yl)-2',4'-bis(hexyloxy)-N-(4-(2,2',3,3'-tetrahydro-[5,5'-bithieno[3,4-b][1,4]dioxin]-7-yl)phenyl)-[1,1',-biphenyl]-4-amine

A mixture of tributyl(2,2',3,3'-tetrahydro-[5,5'-bithieno[3,4-b][1,4]dioxin]-7-yl) stannane (686 mg, 1.2 mmol), Hagfelt donor (0.965 g, 1.1 mmol), Pd(PPh₃)₄ (50 mg, 0.042 mmol), and anhydrous DMF was heated to 90 °C under N₂ for 18 h. The reaction mixture was poured into water (300 mL) and extracted with dichloromethane (3 × 30 mL). The organic layer was separated and washed 3 times with water, dried over anhydrous MgSO₄, and filtered. After removing the solvent, the resulting viscous liquid was purified by column chromatography on silica gel (hexane : dichloromethane = 4 : 1 as eluent) as a thick yellow oil (0.771 g, 65%). ¹H NMR (400 MHz, CD₂Cl₂) δ 7.68 (m, 2 H), 7.48 (m, 4 H), 7.31 (m, 2 H), 7.18 (m, 6 H), 6.58 (m, 4 H), 6.31 (m, 4 H), 4.33 (m, 32 H), 4.02 (m, 8 H), 1.80 (m, 8 H), 1.42 (m, 31 H), 0.95 (m, 16 H).

### 7'-(4-(bis(2',4'-bis(hexyloxy)-[1,1'-biphenyl]-4-yl)amino)phenyl)-2,2',3,3'-tetrahydro-[5,5'-bithieno[3,4-b][1,4]dioxine]-7-carbaldehyde

To a solution of *N*-(2',4'-bis(hexyloxy)-[1,1'-biphenyl]-4-yl)-2',4'-bis(hexyloxy)-*N*-(4-(2,2',3,3'-tetra hydro-[5,5'-bithieno[3,4-*b*][1,4]dioxin]-7-yl)phenyl)-[1,1'-biphenyl]-4-amine (0.573 g, 0.532 mmol) and anhydrous DMF (0.45 mL, 5.58 mmol) in anhydrous 1,2-dichloroethane (60 mL) at 0 °C under a N₂ atmosphere was added POCl₃ (0.52 mL, 5.58 mmol) dropwise, and the mixture was refluxed for 18 h. After being cooled to room temperature, the mixture was poured into an aqueous solution of sodium acetate (1 M, 200 mL) and then stirred for 2 h. The organic phase was separated by decantation and the aqueous phase was extracted with CH2Cl2 (2 x 150 mL). The organic phases were collected, dried over MgSO₄ and evaporated in vacuo. A purification by chromatography on silica gel (eluent: CH2Cl2) gave a orange solid (366 mg, 60% yield). ¹H NMR (400 MHz, CD₂Cl₂) δ 9.92 (m, 1 H), 7.71 (m, 2 H), 7.52 (m, 4 H), 7.32 (m, 2 H), 7.19 (m, 6 H), 6.60 (m, 4 H), 4.45 (m, 12 H), 4.03 (m, 8 H), 1.81 (m, 8 H), 1.42 (m, 24 H), 0.95 (m, 12 H).

### (E)-3-(7'-(4-(bis(2',4'-bis(hexyloxy)-[1,1'-biphenyl]-4-yl)amino)phenyl)-2,2',3,3'-tetrahydro-[5,5'-bithieno[3,4-b][1,4]dioxin]-7-yl)-2-cyanoacrylic acid

To a stirred solution of 7'-(4-(bis(2',4'-bis(hexyloxy)-[1,1'-biphenyl]-4-yl)amino)phenyl)-2,2',3,3'-tetrahydro-[5,5'-bithieno[3,4-*b*][1,4]dioxine]-7-carbaldehyde (570 mg, 0.515 mmol) and cyanoacetic acid (0.13 g, 1.545 mmol) in chloroform (30 mL) was added piperidine (0.305 g, 3.6 mmol). The reaction mixture was refluxed under argon for 12 h and then acidified with 2 M hydrochloric acid aqueous solution (40 mL). The crude product was extracted into chloroform, washed with water, and dried over anhydrous sodium sulfate. After removing solvent under reduced pressure, the residue was purified by flash chromatography with chloroform and subsequently with methanol/chloroform (1/10, v/v) to yield a purple powder (89%). HR-MS (Q-Tof) m/z: 553.0721 [M-H]; calculated for C₇₀H₈₀N₂O₁₀S₂ (M-H): 3974.5105.

## Claims

1. An electrochemical and/or optoelectronic device comprising a cobalt complex operatively connected to a dye-sensitizer of formula
D-π¹-B-π²-A
wherein
D is a π-electron donor group,
A is a π-electron acceptor group,
π¹ and π² are optional bridge groups, and
B is a π-electron bridge group of the formula 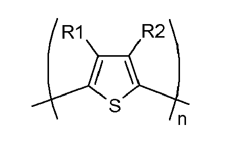
wherein
n is 1, 2, 3, 4, or 5;
R1 and R2 independently are -(O)ₘ-alkyl, -(O)ₘ-cycloalkyl, -(O)ₘ-alkenyl, - (O)ₘ-alkynyl, -(O)ₘ-aryl, or -(O)ₘ-heteroaryl and m is 0 or 1; or R1 and R2 together form an optionally substituted alkylene, an optionally substituted -O-alkylene-O- or an optionally substituted annulated aryl or an optionally substituted annulated heteroaryl.

2. The electrochemical and/or optoelectronic device of claim 1 wherein R1 and R2 together form an optionally substituted -O-alkylene-O-, preferably R1 and R2 together form -O-ethylene-O-.

3. The electrochemical and/or optoelectronic device of claim 1 or 2 wherein A is X and Y are suitably chosen to allow the formation of a coordination complex of acceptor group A with a metal ion, preferably A is X, - (CH=)ₚCHXY, -(CH=)ₚCX₂Y, -(CX=)CHXY, or rhodanine-3-CH₂-X, wherein X and Y are suitably chosen to allow the formation of a coordination complex of acceptor group A with a metal ion, preferably X is -COOH, -PO₃H₂, -PO₄H₂, -SO₃H, -CONHOH, -NO₂, -CN, -NHOH or -(CF₂)ᵣCF₃, and Y is -COOH, -PO₃H₂, -PO₄H₂, -SO₃H, -CONHOH, -NO₂, - CN, -NHOH, -(CF₂)ᵣCF₃ or H; and p and r are independently 0, 1, 2, 3, 4, or 5; more preferably A is -CH=CH(CN)COOH or rhodanine-3-acetic acid.

4. The electrochemical and/or optoelectronic device of any of claims 1 to 3, wherein the π-electron donor group D is selected from: 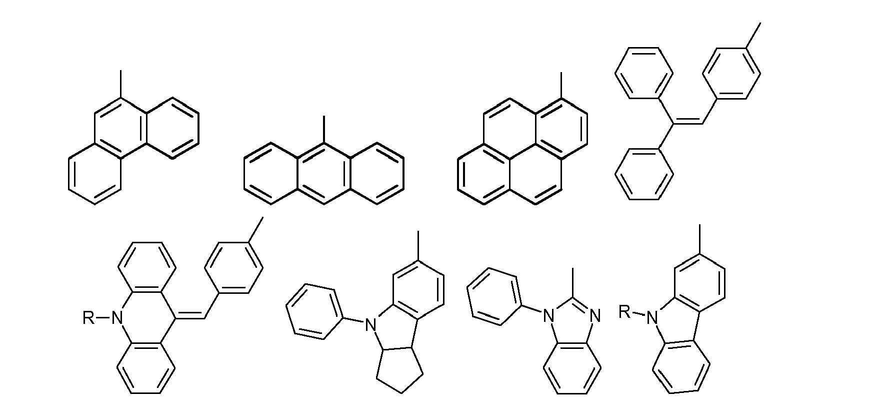 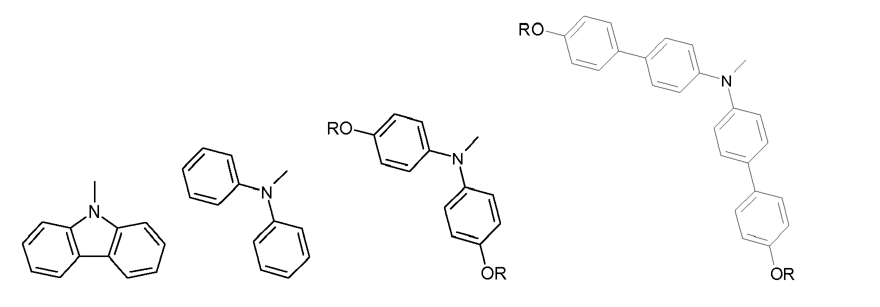 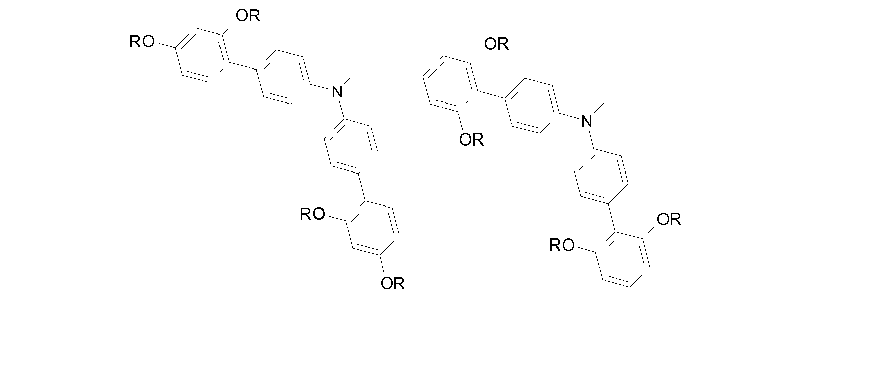 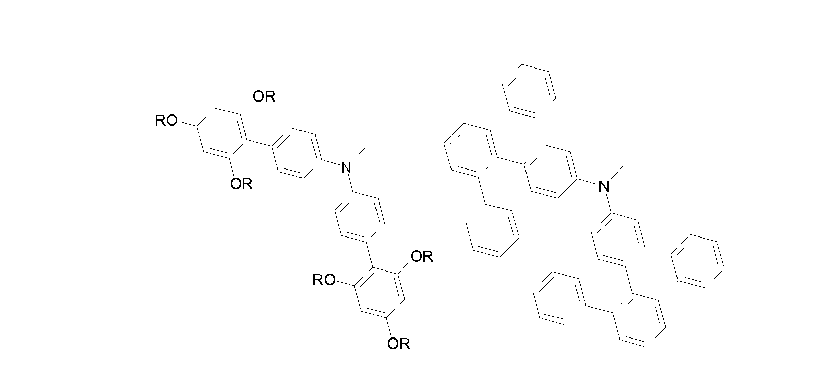 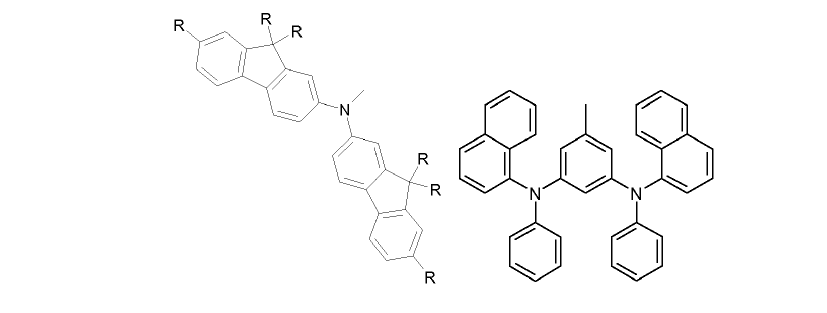 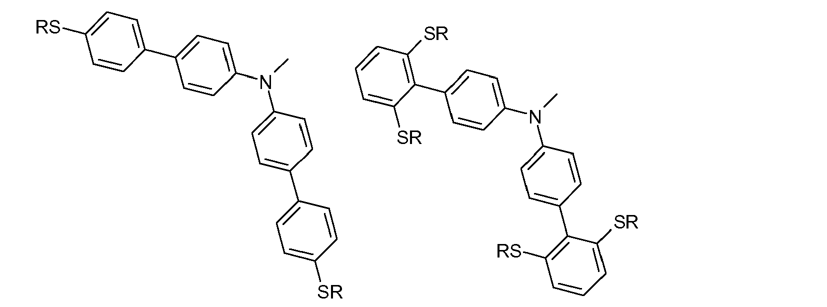 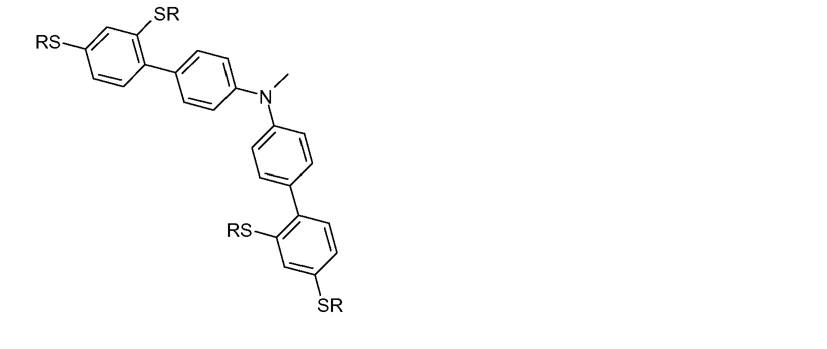 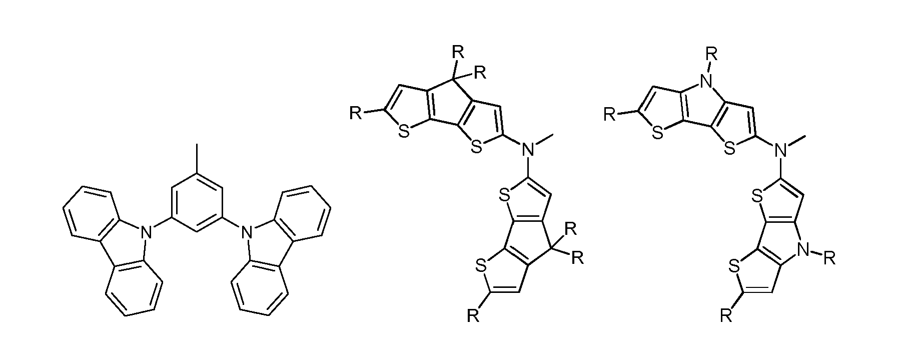 wherein R is independently selected from hydrogen, -CN, optionally branched C1-C18 alkyl and optionally substituted C6-C12 aryl, preferably from optionally branched C6-C12 alkyl and optionally substituted C6 aryl, more preferably from linear C6-C12 alkyl.

5. The electrochemical and/or optoelectronic device of any one of claims 1 to 4, wherein the dye-sensitizer is provided anchored to a semiconductor material, preferably the semiconductor material is selected from the group of titanium salts and tin salts, more preferably the semiconductor material is selected from the group of TiO₂, SnO₂ and TiOF₂, most preferably the dye-sensitizer is anchored to TiOF₂.

6. The electrochemical and/or optoelectronic device of any one of claims 1 to 5, wherein π¹ and π² are selected, independently of each other, from a covalent bond, an aromatic ring system, an alkene, an alkyne or a heteroatom-containing variant of such systems wherein one or more carbon atoms are replaced by a heteroatom, particularly from an alkene group and a phenyl moiety, more particularly from -(CH=CH)ₙ-, wherein n is 1, 2, 3, 4, 5, 6, 7, 8, 9, or 10, or a phenyl group; most preferably π¹ is phenyl and π² is a covalent bond.

7. The electrochemical and/or optoelectronic device of any one of claims 1 to 6, wherein the dye-sensitizer is selected from the group consisting of :

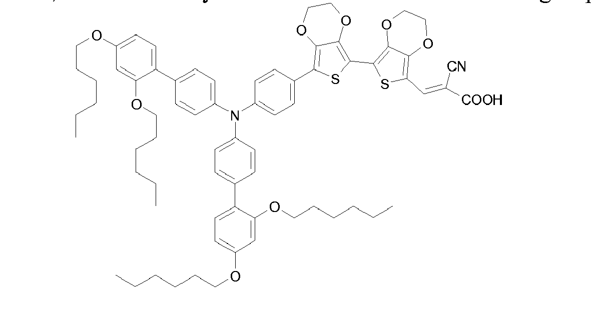

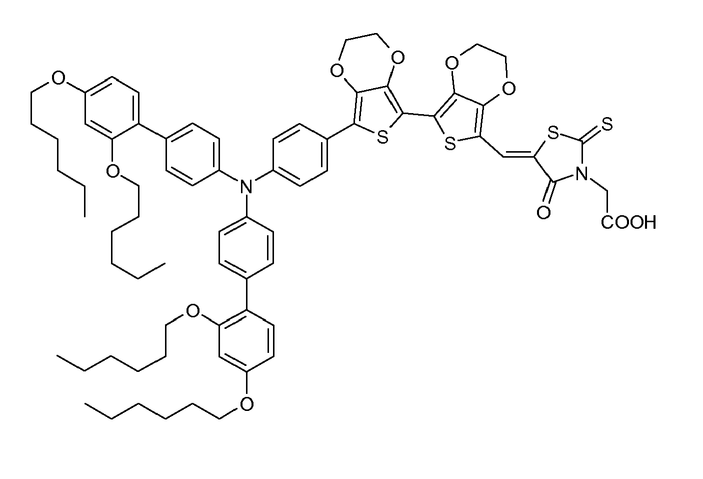

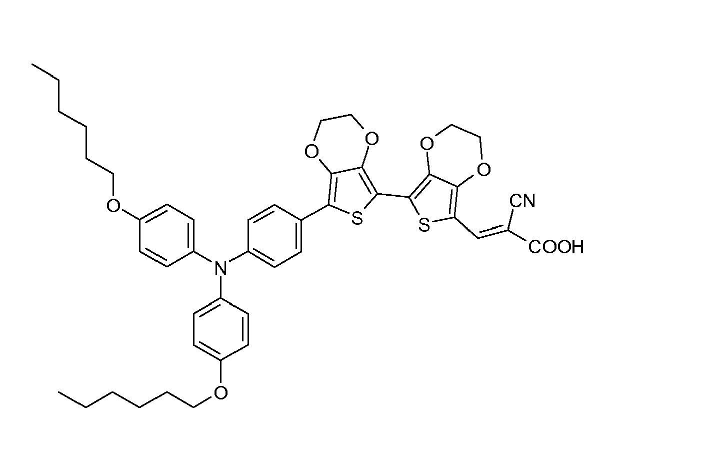

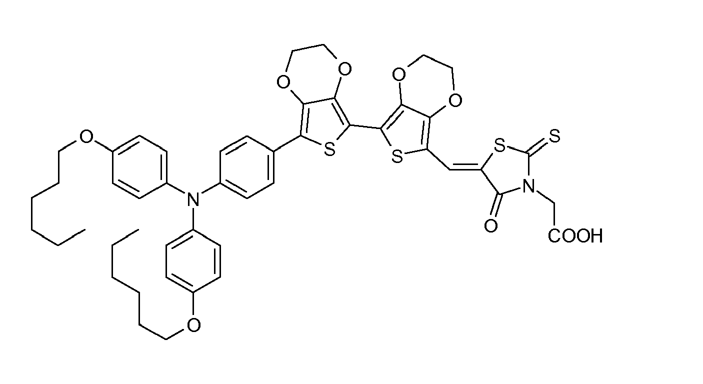

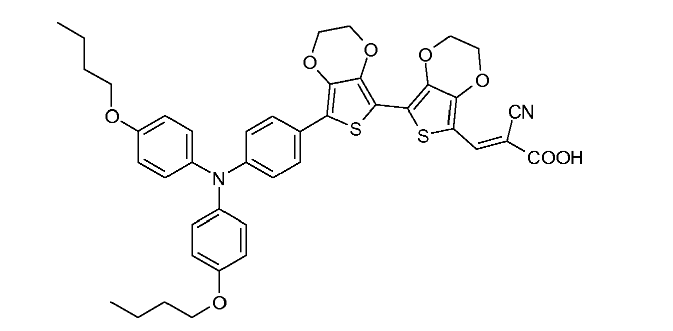

8. The electrochemical and/or optoelectronic device of any one of claims 1 to 7 wherein the cobalt complex is of formula Co^{2+/3+}-L_{q}, wherein
q is 1, 2, 3, 4, 5, or 6, and refers to the appropriate number of ligands present on the cobalt,
L is independently selected from optionally substituted pyridine, optionally substituted pyrazole, optionally substituted pyrazine, optionally substituted triazole, optionally substituted pyridazine, and optionally substituted imidazole or L is independently selected from a bidentate or a tridentate ligand comprising 1, 2, 3, 4, or 5 linked aromatic rings or linked heterocyclic rings or mixtures thereof independently selected from optionally substituted phenyl, optionally substituted naphthyl, optionally substituted pyridine, optionally substituted pyrazole, optionally substituted pyrazine, optionally substituted triazole, optionally substituted pyridazine, and optionally substituted imidazole ; wherein the substituents are independently selected from hydrocarbons comprising 1 to 40 carbon atoms and 0 to 20 heteroatoms, halogen, (-F, -Cl, -Br, -I), -NO₂, -NH₂ and -OH; preferably the cobalt complex is independently selected from:

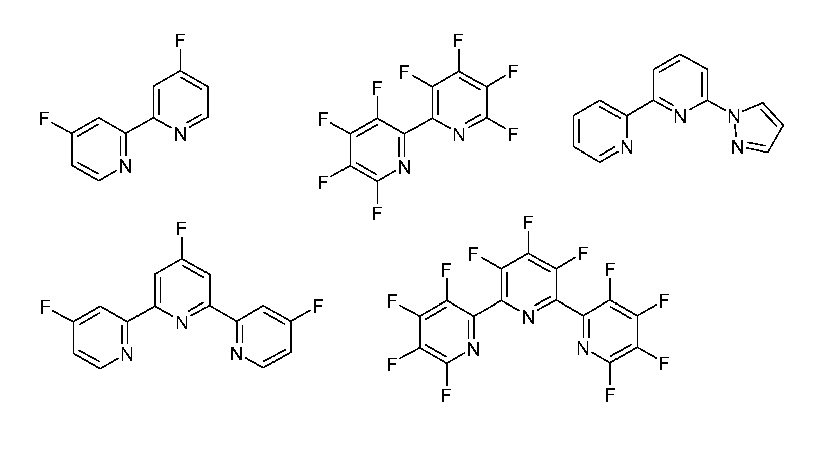

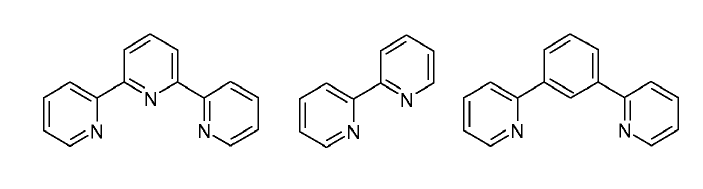

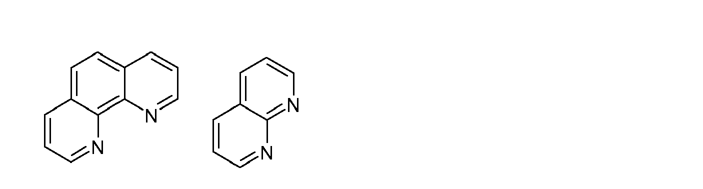

9. A compound of formula
D-π¹-B-π²-A
wherein
D is a π-electron donor group of the general formula 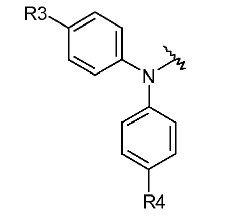
wherein R3 and R4 are independently selected from optionally branched -(O)ₘ-C6-C12-alkyl and optionally substituted C6 aryl,
A is a π-electron acceptor group,
π¹ and π² are optional bridge groups, and
B is a π-electron bridge group of the formula 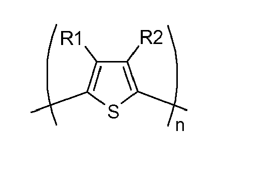
wherein
n is 2, 3, 4, or 5, preferably n is 2;
R1 and R2 independently are -(O)ₘ-alkyl, -(O)ₘ-alkenyl, -(O)ₘ-alkynyl, -(O)ₘ-aryl or -(O)ₘ-heteroaryl, or R1 and R2 together form an optionally substituted -(O)ₘ-alkylene-(O)ₘ or an optionally substituted annulated aryl or an optionally substituted annulated heteroaryl, wherein m is 0 or 1.

10. The compound of claim 9 wherein R3 and R3 independently are selected from linear -O-C6-C12-alkyl and substituted phenyl groups, preferably R3 and R4 independently are selected from -O-n-hexyl or 2,4-di-(n-hexyloxy)phenyl.

11. The compound of claim 9 or 10 wherein R1 and R2 together form -O-ethylene-O-.

12. The compound of any one of claims 9 to 11 wherein π¹ and/or π² are selected, independently of each other, from a covalent bond, an aromatic ring system, an alkene, an alkyne or a heteroatom-containing variant of such systems wherein one or more carbon atoms are replaced by a heteroatom, particularly from an alkene group and a phenyl moiety, more particularly from -(CH=CH)ₙ-, wherein n is 1, 2, 3, 4, 5, 6, 7, 8, 9, or 10, or a phenyl group; most preferably phenyl.

13. The compound of any one of claims 9 to 12 wherein A is X, - (CH=)ₚCHXY, -(CH=)ₚCX₂Y or rhodanine-3-CH₂-X, wherein X and Y are suitably chosen to allow the formation of a coordination complex of acceptor group A with a metal ion; preferably
Xis -COOH, -PO₃H₂, -PO₄H₂, -SO₃H, -CONHOH, -NO₂, -CN, -NHOH or -CF₃ and Y is -COOH, -PO₃H₂, -PO₄H₂, -SO₃H, -CONHOH, -NO₂, -CN, -NHOH, - CF₃ or H; p is 0, 1, 2, 3, 4, or 5; more preferably A is -CH=CH(CN)COOH or rhodanine-3-acetic acid, most preferably A is -CH=CH(CN)COOH.

14. The compound of any one of claims 9 to 13, wherein the organic compound is selected from the group consisting of :

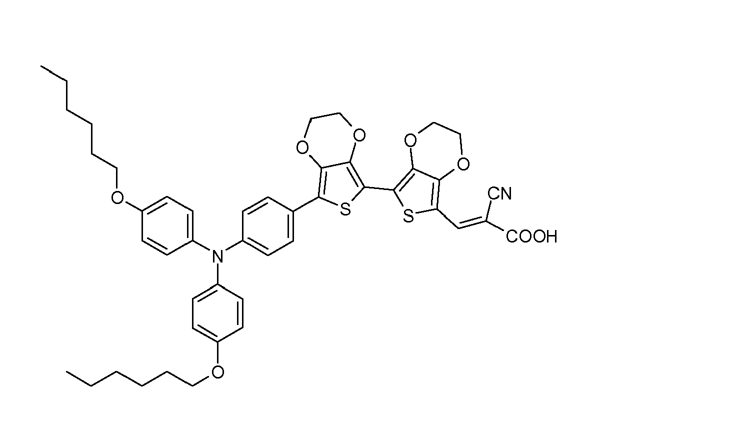

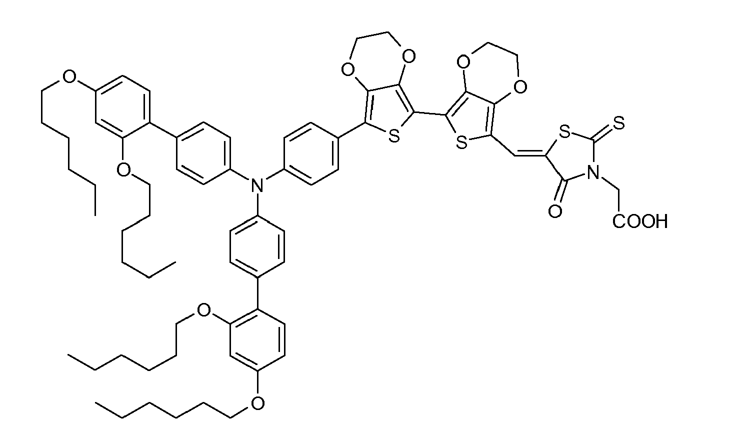

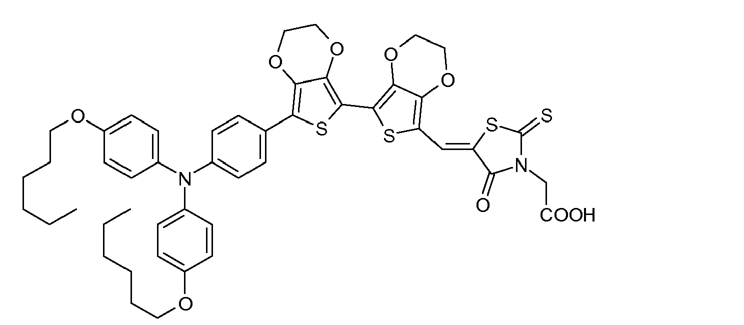

15. An electrochemical and/or optoelectronic device comprising a compound of any one of claims 9 to 14.
